# FASCICULE DE BREVET EUROPEEN

(11) **EP 0 620 290 B1**
(45) Date de publication et mention de la délivrance du brevet: **23.07.1997**
(21) Numéro de dépôt: 94870066.1
(22) Date de dépôt: 14.04.1994
(51) Int. Cl.: C23C 14/34, C23C 14/56

(54) **Procédé pour la formation d'un revêtement sur un substrat par pulvérisation cathodique réactive**
Verfahren zur Herstellung einer dünnen Schicht mittels reaktiver Kathodenzerstäubung
Process for forming a film on a substrate by reactive sputtering

(30) Priorité: 16.04.1993 BE 9300378
(43) Date de publication de la demande: 19.10.1994
(73) Titulaire: Recherche et Développement GROUPE COCKERILL SAMBRE, 4000 Liège (BE)
(72) Inventeur: Winand, René (U.L.B.), B-1330 Rixensart (BE); Lucas, Stéphane (U.L.B.), B-5020 Suarlée (BE); Vanden Brande, Pierre (U.L.B.), B-1040 Bruxelles (BE); Weymeersch, Alain (R.D.C.S.), B-1300 Wavre (BE); Renard, Lucien (R.D.C.S.), B-4100 Seraing (BE)
(74) Mandataire: Claeys, Pierre

(56) Documents cités:
- EP-A- 0 032 788
- EP-A- 0 291 044
- EP-A- 0 383 301

## Description

La présente invention est relative à un procédé pour la formation d'un revêtement sur un substrat par pulvérisation cathodique réactive ("sputtering") dans une enceinte fermée en présence d'un plasma d'un gaz non réactif, tel que de l'argon, et d'un gaz réactif contenant les éléments dont doit être formé le revêtement susdit, suivant lequel on fait usage d'une cible présentant une couche superficielle orientée vers le substrat et contenant au moins un des éléments à déposer sur ce dernier par pulvérisation cathodique, cette pulvérisation étant réalisée dans des conditions telles que cet élément puisse se déposer sur la cible pour former la couche superficielle susdite au départ du gaz réactif et être extraite de cette dernière sous l'effet des ions frappant cette couche pour ensuite se déposer sur le substrat.

Dans les procédés connus du type précité, il y a lieu de renouveler régulièrement la cible par suite du fait que la couche superficielle précitée de celle-ci se consomme lors de la pulvérisation cathodique.

Ceci exige l'arrêt complet de l'installation pour le démontage de la cible et la mise en place d'une nouvelle cible.

Il s'agit généralement d'une opération relativement encombrante nécessitant une main d'oeuvre qualifiée, ce qui la rend donc relativement coûteuse. De plus, le remplacement d'une cible usée par une nouvelle cible risque d'avoir une influence sur l'homogénéité et la qualité du revêtement formé sur le substrat.

Un tel procédé a notamment été décrit dans un article de L.M. Briggs, D.R. Mc Kenzie and R.C. Mc Phedran "Optical constants and microstructure of stainless steal carbon films prepared by reactive magnetron sputtering" Solar Energy Materials 6 (1982) 455/466.

EP-A-0 032 788 décrit un procédé pour la formation d'un revêtement sur un substrat par pulvérisation réactive dans une enceinte fermée en présence d'un plasma d'un gaz réactif contenant le ou les éléments dont doit être formé le revêtement susdit, cette pulvérisation étant réalisée dans des conditions telles que ce ou ces élément(s) puissent se déposer sur la cible pour former une couche superficielle et être éjecté(s) de cette dernière sous l'effet du gaz ionisé pour ensuite se déposer sur le substrat.

Un des buts essentiels de l'invention est de remédier aux inconvénients des procédés existants et ceci d'une manière relativement simple et économiquement justifiée.

A cet effet, suivant l'invention, l'on contrôle l'épaisseur de la couche superficielle précitée de la cible au cours de la pulvérisation cathodique par un réglage de la concentration des gaz dans l'enceinte fermée.

Avantageusement, l'on contrôle l'épaisseur de la couche superficielle de la cible au cours de la pulvérisation cathodique en réglant le rapport des débits respectifs du gaz non réactif et du gaz réactif dans l'enceinte précitée.

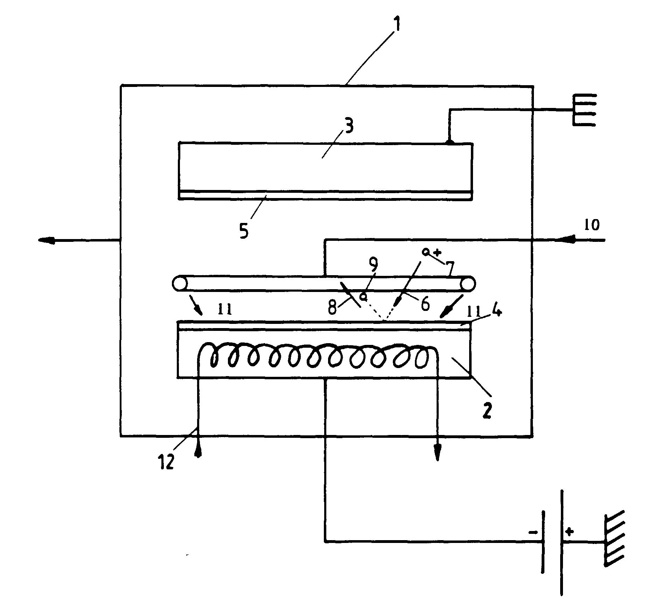

D'autres détails et particularités de l'invention ressortiront de la description donnée ci-après, à titre d'exemples non limitatifs, de quelques formes de réalisations particulières de l'invention avec référence au dessin schématique annexé montrant une installation permettant la mise en oeuvre du procédé suivant l'invention.

Le procédé pour la formation d'un revêtement sur un substrat par pulvérisation cathodique, appelé généralement "sputtering" a lieu dans une enceinte fermée 1 mise sous vide, dans laquelle est montée une cible 2 et un substrat 3 disposé en regard de la cible, à une certaine distance de cette dernière. La cible 2 présente une couche superficielle 4 orientée vers la face du substrat 3 sur laquelle un revêtement 5 doit être formé. Cette couche superficielle 4 présente au moins un des éléments dont doit être constitué le revêtement 5 à déposer sur le substrat 3 par pulvérisation cathodique.

L'enceinte 1 contient un plasma d'un gaz non réactif, tel que de l'argon, et d'un gaz réactif comprenant le ou les élément(s) précité(s).

Dans un procédé de pulvérisation cathodique des atomes sont éjectés de la surface de la couche superficielle 4 et sont déposés sous forme d'un revêtement 5 sur le substrat 3.

Une tension négative est appliquée à la cible 2 et, par conséquent, à la matière de la couche superficielle 4 à éjecter.

Ceci a comme résultat qu'une décharge est générée qui crée le plasma précité formé d'ions, d'électrons et de particules gazeuses neutres.

Des ions chargés positivement sont ainsi accélérés vers la cible à un potentiel négatif pour atteindre cette dernière avec une énergie suffisante provoquant l'éjection d'atomes de la couche superficielle 4. Ces atomes se déplacent en direction du substrat 3 et sont déposés sur ce dernier sous forme d'un revêtement sensiblement uniforme, reproductible et présentant une bonne adhésion à la face du substrat 3.

A la figure annexée la flèche 6 montre schématiquement le déplacement d'un ion positif 7 du plasma vers la cible, tandis que la flèche 8 montre schématiquement l'éjection d'un atome 9 vers le substrat.

La pulvérisation cathodique est réalisée dans des conditions telles que ce ou ces élément(s) du gaz réactif puissent se déposer sur la cible 2 pour former la couche superficielle 4 et être éjecté de cette dernière sous l'effet du gaz ionisé dont les ions positifs frappent cette couche, pour ensuite se déposer sur le substrat 3.

Suivant l'invention, on contrôle l'épaisseur de la couche superficielle 4 sur la cible au cours de la pulvérisation cathodique par un réglage de la concentration des gaz dans l'enceinte fermée 1.

Comme déjà signalé ci-dessus l'on introduit dans l'enceinte 1 un gaz non réactif permettant de former le plasma et un gaz réactif qui contient le ou les élément(s) dont doit être formé le revêtement 5.

Il s'agit plus concrètement d'un gaz réactif susceptible soit de réagir avec les atomes 9 extraits de la cible 2 par pulvérisation de celle-ci, soit de former par ionisation-décomposition des radicaux libres afin d'obtenir sur le substrat 3 le dépôt de composés chimiques contenant des atomes provenant de la cible 2 et d'autres atomes provenant du gaz réactif.

Dans ce cas l'on obtient automatiquement sur la cible la formation de la couche superficielle 4 à partir d'atomes provenant du gaz réactif précité.

L'invention porte sur l'idée de tirer avantage de cette constatation et de créer, par le choix de la nature du gaz réactif, une couche superficielle 4 à partir de laquelle peut être formé le revêtement 5 sur le substrat 3 en appliquant la technique connue de pulvérisation cathodique.

Suivant l'invention on fait usage d'un gaz réactif qui contient tous les atomes nécessaires à la formation du revêtement 5 sur le substrat 3 et l'on règle les paramètres de la pulvérisation cathodique d'une manière telle qu'au moins une partie de ces atomes puissent se déposer sur la cible pour former la couche superficielle 4 susdite et être éjectés de cette dernière sous l'action du gaz ionisé pour se déposer ensuite sur le substrat 3.

Avantageusement, afin d'éviter de consommer la cible, les paramètres du procédé sont choisis de telle sorte que la cible soit pulvérisée sensiblement à la même vitesse que celle à laquelle se forme ladite couche superficielle 4.

Ainsi, suivant une forme de réalisation particulière de l'invention, on maintient les conditions de génération du plasma sensiblement constante. De même on choisit et on maintient constante la proportion de gaz réactif dans le mélange gazeux introduit dans l'enceinte 1.

Il a été constaté, suivant l'invention, qu'afin d'améliorer la formation sur la cible 2 de la couche superficielle 4, il est utile de diriger le gaz réactif vers le plasma et notamment vers la cible 1.

Suivant une forme de réalisation particulière, le gaz réactif est amené dans l'enceinte 1 au moyen d'une douche 10 dont les éjecteurs sont orientés vers la cible 2, comme indiqué sur la figure par les flèches 11.

Grâce au procédé suivant l'invention, il est possible de former un revêtement 5 sur le substrat formé, d'un film de carbone hydrogéné au départ d'une cible auto-alimentée en carbone par un gaz hydrocarboné .

Il est également possible de former d'autres revêtements (métaux, non-métaux, composés définis, solutions solides et composés hors équilibre) en alimentant l'enceinte 1 par des gaz réactifs adequats.

La cible 2 peut être alimentée en courant continu ou alternatif. De plus, un champ magnétique perpendiculaire au champ électrique peut être créé au moyen d'un aimant permanent ou d'un électroaimant, non représenté à la figure, afin d'augmenter l'ionisation des gaz du plasma.

La distance entre la cible 2 et le substrat 3 est généralement de l'ordre de quelques cm, dépendant des autres paramètres du procédé, tels que dimension de l'enceinte, débit des gaz, tension du courant électrique etc...

Par ailleurs, la cible est avantageusement refroidie. Ceci a été montré schématiquement à la figure par la conduite spiralée 12 incorporée dans la cible 2, dans laquelle peut par exemple circuler de l'eau de refroidissement.

Généralement, on règle la pression dans l'enceinte 1 entre 133 Pa et 1,33x10⁻³ Pa (1 et 10⁻⁵ torr), de préférence entre 13,3 Pa et 1,33x10⁻² Pa (0,1 et 10⁻⁴ torr).

Le plasma peut être généré par un courant électrique continu à effet de champ magnétique dont la densité de courant sur la cible est comprise entre 10⁻³ et 1 A.cm⁻², de préférence entre 10⁻³ et 0,03 A.cm⁻².

Afin de pouvoir former un revêtement 5 hydrocarboné, on utilise un gaz réactif constitué essentiellement d'acétylène, tandis que le gaz non réactif est avantageusement constitué d'argon.

Dans un tel cas, on règle avantageusement les débits respectifs de ces deux gaz pour obtenir un rapport en volume gaz réactif/gaz non réactif dans l'enceinte 1 compris entre 1 et 10⁻³, de préférence entre 10⁻¹ et 10⁻².

Le contrôle de l'épaisseur de la couche superficielle 4 sur la cible 2 peut être effectué par des moyens connus, telle qu'une analyse de la composition des gaz dans l'enceinte 1, par spectrométrie d'émission optique ou par spectrométrie de masse.

A cet effet, on fait avantageusement usage d'une cible 2 dont la surface, sur laquelle est formée la couche superficielle 4, contient des éléments non-nocifs pour le revêtement à former sur le substrat et ne pouvant pas perturber le bon fonctionnement de la pulvérisation cathodique. Ainsi, au moment où la couche superficielle est pratiquement consommée de tels éléments pourraient être éjectés de la cible et donc être présents dans les gaz contenus dans l'enceinte. Dès que l'on constate la présence de tels éléments, il suffit d'augmenter le débit en gaz réactif. De cette façon, on obtient une variation périodique de l'épaisseur de la couche superficielle 4 sur la cible 2.

Toutefois, suivant une forme préférentielle de l'invention, on règle le débit et la proportion des gaz de manière à maintenir l'épaisseur de la couche superficielle sensiblement constante durant toute l'opération de pulvérisation cathodique.

Ci-après sont donnés deux exemples concrets de formation d'un revêtement sur un substrat par le procédé de pulvérisation cathodique réactive suivant l'invention.

### Exemple 1

Cet exemple concerne la formation d'un revêtement 5 à base de carbone. Le gaz réactif utilisé était constitué d'acétylène, tandis que le gaz non-réactif était constitué d'argon.

L'installation utilisée était uniquement à courant continu à effet de champ magnétique (magnétron d.c.).

La pression dans l'enceinte des gaz était de 0,67 Pa (5.10⁻³ torr), tandis que la densité de courant électrique sur la cible était de 10 mA.cm⁻².

Le débit respectif des deux gaz était réglé de manière à obtenir des teneurs en volume d'acétylène = 7 et argon = 93.

Du carbone a été déposé sur la cible à la même vitesse qu'il est pulvérisé et contenait environ 10 % d'hydrogène.

Le dépôt effectué sur le substrat était formé d'un polymère à rapport C/H = 1.

Le plasma observé par spectrométrie d'émission optique était constitué de Ar, Ar⁺, C, C₂, H, CH⁺ et CH.

### Exemple 2

Dans cet exemple le revêtement est formé d'aluminium.

Le gaz non réactif utilisé était l'argon, tandis que le gaz réactif était formé de triméthyl aluminium. Le même équipement que celui de l'exemple 1 a été utilisé.

Le gaz était maintenu à une pression de 0,67 Pa (5.10⁻³ torr) dans l'enceinte, tandis que la densité de courant sur la cible était de 15 mA.cm⁻².

Le mélange gazeux contenait en volume 25 % de triméthyl aluminium et 75 % d'argon.

La couche superficielle 4 sur la cible 2 contenait essentiellement de l'aluminium. Le revêtement sur le substrat était formé d'un film d'aluminium de haute pureté.

## Revendications

1. Procédé pour la formation d'un revêtement (5) sur un substrat (3) par pulvérisation cathodique réactive ("sputtering") dans une enceinte fermée (1) en présence d'un plasma d'un gaz non réactif, tel que de l'argon, et d'un gaz réactif contenant le ou les éléments dont doit être formé le revêtement susdit, suivant lequel on fait usage d'une cible (2) présentant une couche superficielle (4) orientée vers le substrat, ladite couche superficielle (4) contenant au moins un des éléments à déposer sur ce dernier par pulvérisation cathodique, cette pulvérisation étant réalisée dans des conditions telles que ce ou ces élément(s) puissent se déposer sur la cible (2) pour former la couche superficielle (4) susdite et être éjecté(s) de cette dernière sous l'effet du gaz ionisé pour ensuite se déposer sur le substrat (3), et que l'on contrôle l'épaisseur de cette couche superficielle (4) au cours de la pulvérisation cathodique par un réglage de la concentration des gaz dans l'enceinte fermée susdite (1).

2. Procédé suivant la revendication 1, caractérisé en ce que l'on contrôle l'épaisseur de la couche superficielle (4) de la cible (2) au cours de la pulvérisation cathodique en réglant le rapport des débits respectifs du gaz non réactif et du gaz réactif dans l'enceinte précitée (1).

3. Procédé suivant les revendications 1 et 2, caractérisé en ce qu'il est fait usage d'une pulvérisation cathodique à courant continu et/ou alternatif.

4. Procédé suivant l'une quelconque des revendications 1 à 3, caractérisé en ce que l'on utilise un gaz réactif contenant de l'acétylène et/ou du triméthyl aluminium.

5. Procédé suivant l'une quelconque des revendications 1 à 4, caractérisé en ce que l'on règle la pression dans l'enceinte entre 133 Pa et 1,33.10⁻³ Pa (1 torr et 10⁻⁵torr).

6. Procédé suivant la revendication 5, caractérisé en ce que l'on règle la pression dans l'enceinte entre 13,3 Pa et 1,33.10⁻² Pa (0,1 et 10⁻⁴torr).

7. Procédé suivant l'une ou l'autre des revendications 1 à 6, caractérisé en ce que l'on génère le plasma par un courant électrique continu à effet de champ magnétique dont la densité sur la cible est comprise entre 10⁻³et 1 A.cm⁻².

8. Procédé suivant la revendication 7, caractérisé en ce que l'on applique un courant électrique continu dont la densité sur la cible est de 10-3 à 0,03 Acm⁻².

9. Procédé suivant l'une quelconque des revendications 1 à 8, caractérisé en ce que, le gaz non réactif étant de l'argon et le gaz réactif de l'acétylène, l'on règle les débits respectifs de ces deux gaz pour obtenir un rapport en volume dans l'enceinte précitée compris entre 1 et 10⁻³.

10. Procédé suivant la revendication 9, caractérisé en ce que l'on règle les débits respectifs précités pour obtenir un rapport en volume dans l'enceinte précitée compris entre 10⁻¹et 10⁻².

11. Procédé suivant l'une quelconque des revendications 1 à 10, caractérisé en ce que l'on contrôle l'épaisseur de la couche superficielle par une analyse de la composition des gaz dans l'enceinte fermée (1).

## Patentansprüche

1. Verfahren zur Bildung einer Beschichtung (5) auf einem Substrat (3) mittels reaktiver Kathodenzerstäubung ("sputtering") in einer geschlossenen Kammer (1) in Gegenwart eines Plasmas eines nichtreaktiven Gases, wie z.B. von Argon, und eines reaktiven Gases, welches das oder die Elemente enthält, aus denen die vorstehend genannte Beschichtung gebildet werden soll, bei dem ein Target (2) verwendet wird, welches eine gegen das Substrat gerichtete Oberlächenschicht (4) aufweist, wobei die genannte Oberflächenschicht (4) mindestens eines der Elemente enthält, die auf diesem letzteren mittels Kathodenzerstäubung abzuscheiden sind, wobei diese Zerstäubung unter solchen Bedingungen durchgeführt wird, daß dieses Element oder diese Elemente sich auf dem Target (2) abscheiden können, um die oben genannte Oberflächenschicht (4) zu bilden, und aus dieser letzteren unter der Wirkung des ionisierten Gases herausgestoßen werden können, um sich daraufhin auf dem Substrat (3) abzuscheiden, und daß die Dicke dieser Oberflächenschicht (4) während der Kathodenzerstäubung mittels einer Regelung der Konzentration der Gase in der oben genannten geschlossenen Kammer (1) gesteuert oder geregelt wird.

2. Verfahren nach Anspruch 1, dadurch gekennzeichnet, daß die Dicke der Oberflächenschicht (4) des Targets (2) während der Kathodenzerstäubung gesteuert oder geregelt wird, indem das Verhältnis der jeweiligen Durchflüsse des nichtreaktiven Gases und des reaktiven Gases in der vorstehend genannten Kammer (1) geregelt wird.

3. Verfahren nach den Ansprüchen 1 oder 2, dadurch gekennzeichnet, daß eine Gleichstrom- und/oder Wechselstrom-Kathodenzerstäubung verwendet wird.

4. Verfahren nach einem der Ansprüche 1 bis 3, dadurch gekennzeichnet, daß ein reaktives Gas verwendet wird, welches Acetylen und/oder Trimethylaluminium enthält.

5. Verfahren nach einem der Ansprüche 1 bis 4, dadurch gekennzeichnet, daß der Druck in der Kammer zwischen 133 Pa und 1,33 · 10⁻³ Pa (1 Torr und 10⁻⁵ Torr) geregelt wird.

6. Verfahren nach Anspruch 5, dadurch gekennzeichnet, daß der Druck in der Kammer zwischen 13,3 Pa und 1,33 · 10⁻² Pa (0,1 und 10⁻⁴ Torr) geregelt wird.

7. Verfahren nach einem der Ansprüche 1 bis 6, dadurch gekennzeichnet, daß das Plasma mittels eines elektrischen Magnetfeldeffekt-Gleichstroms erzeugt wird, dessen Dichte auf dem Target zwischen 10⁻³ und 1 A · cm⁻² liegt.

8. Verfahren nach Anspruch 7, dadurch gekennzeichnet, daß ein elektrischer Gleichstrom angewandt wird, dessen Dichte auf dem Target 10⁻³ bis 0,03 Acm⁻² beträgt.

9. Verfahren nach einem der Ansprüche 1 bis 8, dadurch gekennzeichnet, daß das nichtreaktive Gas Argon und das reaktive Gas Acetylen ist und daß die jeweiligen Durchflüsse dieser beiden Gase so geregelt werden, daß in der vorstehend genannten Kammer ein Volumenverhältnis erhalten wird, welches zwischen 1 und 10⁻³ liegt.

10. Verfahren nach Anspruch 9, dadurch gekennzeichnet, daß die vorstehend genannten jeweiligen Durchflüsse so geregelt werden, daß in der vorstehend genannten Kammer ein Volumenverhältnis erhalten wird, welches zwischen 10⁻¹ und 10⁻² liegt.

11. Verfahren nach einem der Ansprüche 1 bis 10, dadurch gekennzeichnet, daß die Dicke der Oberflächenschicht mittels einer Analyse der Zusammensetzung der Gase in der geschlossenen Kammer (1) gesteuert oder geregelt wird.

## Claims

1. Process for forming a coating (5) on a substrate (3) by reactive cathodic sputtering in a closed chamber (1) in the presence of a plasma of an unreactive gas, such as argon, and of a reactive gas containing the element or elements from which the abovementioned coating is to be formed, in which use is made of a target (2) having a surface layer (4) facing the substrate, the said surface layer (4) containing at least one of the elements to be deposited on the latter by cathodic sputtering, this sputtering being carried out under conditions such that this or these element(s) can be deposited on the target (2) in order to form the abovementioned surface layer (4) and can be ejected from the latter under the effect of the ionized gas, to be then deposited on the substrate (3), and such that the thickness of this surface layer (4) is controlled during the cathodic sputtering by adjusting the concentration of the gases in the aforementioned closed chamber (1).

2. Process according to Claim 1, characterized in that the thickness of the surface layer (4) of the target (2) is controlled during the cathodic sputtering by adjusting the ration of the respective flow rates of the unreactive gas and of the reactive gas in the abovementioned chamber (1).

3. Process according to Claims 1 and 2, characterized in that it makes use of DC and/or AC cathodic sputtering.

4. Process according to any one of Claims 1 to 3, characterized in that a reactive gas containing acetylene and/or trimethylaluminium is used.

5. Process according to any one of Claims 1 to 4, characterized in that the pressure in the chamber is set between 133 Pa and 1.33 × 10⁻³ Pa (1 torr and 10⁻⁵ torr).

6. Process according to Claim 5, characterized in that the pressure in the chamber is set between 13.3 Pa and 1.33 × 10⁻² Pa (0.1 and 10⁻⁴ torr).

7. Process according to any one of Claims 1 to 6, characterized in that the plasma is generated by a DC electric current, with a magnetic-field effect, the current density on the target being between 10⁻³ and 1 A.cm⁻².

8. Process according to Claim 7, characterized in that a DC electric current is applied, the current density on the target being from 10⁻³ to 0.03 A.cm⁻².

9. Process according to any one of Claims 1 to 8, characterized in that, the unreactive gas being argon and the reactive gas acetylene, the respective flow rates of these two gases are adjusted in order to obtain a volume ratio in the aforementioned chamber of between 1 and 10⁻ ³.

10. Process according to Claim 9, characterized in that the aforementioned respective flow rates are adjusted in order to obtain a volume ratio in the aforementioned chamber of between 10⁻¹ and 10⁻².

11. Process according to any one of Claims 1 to 10, characterized in that the thickness of the surface layer is monitored by analysing the composition of the gases in the closed chamber (1).
